# EUROPEAN PATENT SPECIFICATION

(11) **EP 2 372 905 B1**
(45) Date of publication and mention of the grant of the patent: **20.06.2012**
(21) Application number: 10290175.8
(22) Date of filing: 01.04.2010
(51) Int. Cl.: H03F 1/02, H03F 3/24, H03G 3/00, H04W 52/18

(54) **Efficiency-improved Doherty amplifier arrangement**
Doherty-Verstärkeranordnung mit verbessertem Wirkungsgrad
Montage d'amplificateur de Doherty à rendement amélioré

(43) Date of publication of application: 05.10.2011
(73) Proprietor: Alcatel Lucent, 75007 Paris (FR)
(72) Inventor: Wiegner, Dirk, 71409 Schwaikheim (DE); Luz, Gerhard, 74321 Bietigheim-Bissingen (DE)
(74) Representative: Wetzel, Emmanuelle

(56) References cited:
- EP-A1- 1 394 932
- EP-A2- 1 959 564
- WO-A1-98/00912
- JUNGHWAN MOON ET AL: "A Wideband Envelope Tracking Doherty Amplifier for WiMAX Systems" IEEE MICROWAVE AND WIRELESS COMPONENTS LETTERS, IEEE SERVICE CENTER, NEW YORK, NY, US LNKD- DOI:10.1109/LMWC.2007.912019, vol. 18, no. 1, 1 January 2008 (2008-01-01), pages 49-51, XP011199213 ISSN: 1531-1309
- JOONGJIN NAM ET AL: "The Doherty Power Amplifier With On-Chip Dynamic Bias Control Circuit for Handset Application" IEEE TRANSACTIONS ON MICROWAVE THEORY AND TECHNIQUES, IEEE SERVICE CENTER, PISCATAWAY, NJ, US LNKD- DOI:10.1109/TMTT.2007.892800, vol. 55, no. 4, 1 April 2007 (2007-04-01), pages 633-642, XP011176523 ISSN: 0018-9480

## Description

### Field of the Invention

The invention relates to the field of telecommunications, and, more specifically, to efficiency improvements of Doherty amplifiers used for signal amplification e.g. in base stations of wireless communications networks.

### Background

This section introduces aspects that may be helpful in facilitating a better understanding of the invention. Accordingly, the statements of this section are to be read in this light and are not to be understood as admissions about what is in the prior art or what is not in the prior art.

Doherty amplifiers typically comprise two parallel amplification paths for an input signal: A main amplification path with a main amplifier biased to work in class A/B mode, and an auxiliary amplification path with a peak amplifier biased to operate in class C mode, as well as two quarter-wave sections, each being arranged in a respective amplification path. In the Doherty amplifier configuration, during high signal peaks of the input signal, the main amplifier saturates and the peak amplifier takes over. Thus, a Doherty amplifier provides a high power-added efficiency with input signals that have high peak-to-average ratios.

Yet, although a theoretical efficiency of a Class-A (50 % peak efficiency) and a Class-B (78 % peak efficiency) based Doherty amplifier is quite good also for high back-off conditions (e.g. about 50 % or less of the maximum possible power), experiments show that the actual efficiency of a Doherty amplifier clearly differs from the theoretically expected efficiency. This is e.g. due to the fact that the auxiliary amplifier is permanently biased in Class-C mode and thus doesn't always deliver the optimum required performance for a Doherty configuration.

On a concept level, one approach for improving efficiency would be switching a supply voltage (drain-source voltage when a Field Effect Transistor (FET) is used) of the main amplifier depending on the load condition (e.g. daytime - nighttime), or alternatively adapting the input supply voltage (gate-source voltage for a FET) of the peak transistor. Both mentioned approaches improve efficiency, but still with clear room for improvement as compared to the theoretical Doherty limits. On the other hand, concepts like Envelope Tracking based on bias modulation of conventional Class-AB amplifiers are known, supplying the Class-AB amplifier with a modulation voltage depending on the envelope signal and the load condition of the Class-AB amplifier. However, when the Envelope Tracking solution is chosen, a specific supply voltage modulator is required which is challenging to implement.

Documents EP-A-1959564 and "A wideband Envelope tracking Doherty Amplifier for WIMAX systems" by Junghwon Moon and others, IEEE Microwave and wireless components letters, Vol. 18, N° 1, January 2008, constitute examples of Doherty amplifiers of the prior art.

### Summary

The present invention is directed to addressing the effects of one or more of the problems set forth above. The following presents a simplified summary of the invention in order to provide a basic understanding of some aspects of the invention. This summary is not an exhaustive overview of the invention. It is not intended to identify key or critical elements of the invention or to delineate the scope of the invention. Its sole purpose is to present some concepts in a simplified form as a prelude to the more detailed description that is discussed later.

One aspect of the invention relates to a Doherty amplifier arrangement as defined in claim 1.

The inventors propose to combine switching the (output) supply voltage of the main amplifier and typically also of the peak amplifier between different discrete values in dependence of the load (realizing a comparatively slow adaptation) with a signal-envelope related modulation of an input supply voltage provided to the peak amplifier (realizing a comparatively fast adaptation with quasi-continuous voltage levels). By combining both approaches, the efficiency at low to high back-off operation (i.e. for different load situations) as well as the peak efficiency of the Doherty amplifier arrangement can be improved. Thus, a common Doherty amplifier concept can be realized which leads to an additionally improved efficiency as compared to the single approaches.

In one embodiment, the peak amplifier control unit is adapted for modulating the input supply voltage of the peak amplifier also in dependence of a load condition and/or of a quality of an output signal of the Doherty amplifier arrangement. Thus, in addition to the dependence on the envelope signal, the input supply voltage may also be chosen in dependence of the load condition and/or on the output signal of the Doherty amplifier. Thus, instead of using a single characteristic function for mapping amplitude values of the envelope signal to values of the input supply voltage of the peak amplifier, a plurality of functions may be used, each function being defined for a different load condition / quality of the output signal. In this respect, it should be noted that when a feedback path is implemented in the Doherty amplifier arrangement, e.g. for digital pre-distortion, the knowledge of the output signal will be available in the Doherty amplifier arrangement anyhow, such that no additional components will be needed for detecting the amplified signal at the amplifier's output.

The Doherty amplifier arrangement is adapted for switching the output supply voltage of the main amplifier and for modulating the input supply voltage of the peak amplifier in a coordinated way. Typically, the output supply voltage of the main amplifier (and of the peak amplifier) as well as the input supply voltage of the peak amplifier are switched / adapted in dependence of the load, resulting in a load-dependent coordination of both approaches. For each discrete value of the output supply voltage of the main amplifier (typically corresponding to a different load scenario chosen from a discrete set of load scenarios), a different function relating the envelope signal to the input supply voltage is used.

In another embodiment, at least one of the peak amplifier control unit and the main amplifier control unit are further adapted for switching an output supply voltage of the peak amplifier in dependence of a load condition of the Doherty amplifier arrangement. Typically, the output supply voltage (e.g. drain-source voltage of a FET) of the peak amplifier will be switched only in dependence of the load condition, i.e. the output supply voltage will also be chosen from a discrete set of values (in general not more than ten values, typically five or less values, corresponding to different load scenarios).

In a further embodiment, the peak amplifier control unit comprises at least one look-up table relating the input supply voltage to the envelope of the input signal. As the adaptation of the input supply voltage has to be performed in a rapid way, a look-up table may be used for quickly determining a current value of the input supply voltage from a plurality of parameters (signal envelope, load, possibly output signal quality).

In one improvement, the Doherty amplifier arrangement comprises a plurality of look-up tables, each for a different load condition of the Doherty amplifier arrangement. For instance, three look-up tables may be provided a first one for a low load scenario, a second one for a mid load scenario, and a third one for a high load scenario, respectively. The look-up tables may be implemented e.g. in a Field Programmable Gate Array, FPGA, or other suitable device. Following the look-up table, a suitable interface adaptation and an adaptive power supply may be used to provide the adaptive input supply voltage to the peak amplifier. It will be understood that in addition to the load, further input parameters may be provided, so that a plurality of look-up tables may be used, each look-up table corresponding to a specific combination of the input parameters.

In another embodiment, the main amplifier control unit comprises a switchable power supply for generating a plurality of discrete voltage levels to be provided as supply voltages to the main amplifier. For instance, for the low, mid, and high load scenario, a voltage level of e.g. 15 V, 20 V, or 30 V may be used. The switchable (DC) power supply may e.g. comprise a DC-to-DC converter for switching between the different voltage levels. Typically, the switching between the discrete voltage levels is performed at a switching frequency smaller than 100 kHz. The switchable power supply of the main amplifier control unit may also be used for providing the (output) supply voltage for the peak amplifier. In this case, the (output) supply voltage provided to the main amplifier and the peak amplifier will be identical and both will be switched e.g. between the three voltage levels of 15 V, 20 V, or 30 V, respectively.

A further aspect of the invention relates to a transmit frontend for a base station, comprising a Doherty amplifier arrangement as described above. The transmit frontend typically has a digital frontend unit which is adapted to generate a (digital) baseband signal which is Analog-to-Digital converted before being up-converted to the RF domain, the up-converted signal being provided to the Doherty amplifier arrangement as an input signal for amplification. The output signal after amplification will then be provided to an antenna for radio transmissions (via a suitable antenna network). As the digital frontend generates the input signal, the digital frontend typically has both the information about the load condition and the envelope of the input signal which is provided to the Doherty amplifier arrangement, such that it is ideally suited for implementing at least part of the main amplifier control unit and the peak amplifier control unit.

The transmit frontend is typically part of a base station for mobile radio applications, which is used in a wireless network e.g. of the LTE advanced standard, the Wimax standard, etc.

Another aspect of the invention is realized in a method for amplification of an input signal which is provided to a Doherty amplifier arrangement having a main amplifier and a peak amplifier, the method comprising: switching a supply voltage of the main amplifier in dependence of a load condition of the Doherty amplifier arrangement, and modulating an input supply voltage of the peak amplifier in dependence of an envelope of the input signal. As indicated above, combining a slow adaptation ("switching") of the (output) supply voltage of the main amplifier using only a small discrete set of supply voltage values with a faster (continuous or quasi-continuous) adaptation of the (input) supply voltage of the auxiliary amplifier may lead to a considerable efficiency improvement of the Doherty amplifier arrangement. Typically, the lower the load of the Doherty amplifier arrangement, the smaller the (output) supply voltage provided to the main amplifier.

In one variant, the modulating of the input supply voltage of the peak amplifier is performed also in dependence of a load condition and/or of a quality of an output signal of the Doherty amplifier arrangement. In particular, the modulation of the input supply voltage may be different for different (typically discrete) load scenarios. Also, the quality (e.g. linearity) of the output signal may be taken into account for the modulation, e.g. in order to avoid a decrease of the output signal linearity.

In another variant, the switching of the supply voltage of the main amplifier and the modulating of the input supply voltage of the peak amplifier are performed in a coordinated way. In particular, when both supply voltages are load-dependent, the load is a parameter which influences both supply voltages, such that both supply voltages will be coordinated based on the load.

In yet another variant the method further comprises: switching an output supply voltage of the peak amplifier in dependence of a load condition of the Doherty amplifier arrangement. The output supply voltage of the peak amplifier may be switched in an analogous way as the output supply voltage of the main amplifier, i.e. the value of the output supply voltage may decrease with decreasing load.

In one variant, the method further comprises: relating the input supply voltage to the envelope of the input signal using at least one look-up table, preferably using a plurality of look-up tables for different load conditions (or other conditions) of the Doherty amplifier arrangement. The envelope signal of the input signal provided to the Doherty amplifier may be determined e.g. in a digital frontend which may be implemented e.g. as an FPGA, a look-up table being used for quickly relating a current value of the envelope signal to an adequate input supply voltage for the peak amplifier:

A final aspect of the invention is implemented in a computer program product adapted to perform all the steps of the method described above, the computer program product being implemented in suitable software and/or hardware.

Further features and advantages are stated in the following description of exemplary embodiments, with reference to the figures of the drawing, which shows significant details, and are defined by the claims. The individual features can be implemented individually by themselves, or several of them can be implemented in any desired combination.

### Brief Description of the Figures

Exemplary embodiments are shown in the diagrammatic drawing and are explained in the description below. The following are shown:
- **Fig. 1**: shows a schematic diagram of an Doherty amplifier arrangement according to the state of the art,
- **Fig. 2**: shows a schematic diagram of the load-dependent efficiency of the Doherty amplifier of Fig. 1,
- **Fig.3**: shows a schematic diagram of an embodiment of a Doherty amplifier arrangement according to the invention, and
- **Fig.4**: shows an exemplary scenario of a supply voltage / bias adaptation which is implemented in the Doherty amplifier arrangement of Fig. 3.

### Description of the Embodiments

The functions of the various elements shown in the Figures, including any functional blocks labeled as 'processors', may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term 'processor' or 'controller' should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

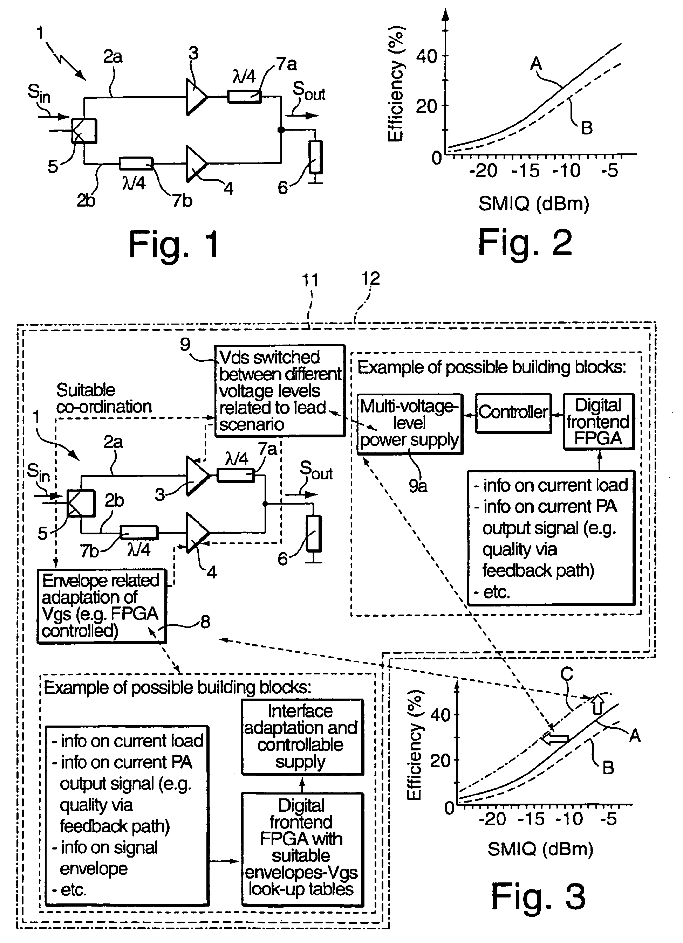

The classical configuration of a conventional Doherty (power) amplifier arrangement 1 is shown in **Fig. 1**. The Doherty amplifier 1 comprises a main amplification path **2a** with a main amplifier 3 biased to work in class A, AB or class B mode, and an auxiliary amplification path **2b** with a peak amplifier **4** biased to operate in class C mode. A power divider (passive splitter **5**) splits an input signal **Sᵢₙ** with equal power to the main amplification path 2a and to the auxiliary amplification path 2b. After amplification, the auxiliary amplification path 2b and the main amplification path 2a are re-combined in a power combiner (not shown) at a combining point (represented by a dot in Fig. 1) while guaranteeing suitable output load modulation.

For optimized load balancing, a first quarter wave section **7a** is arranged in the main amplification path 2a between an output terminal of the main amplifier 3 and the combining point and a second quarter wave section **7b** is arranged in the auxiliary amplification path 2b between the splitter 5 and an input terminal of the auxiliary / peak amplifier **4**. The quarter-wave sections 7a, 7b are matched to a common center frequency of the main amplifier 3 and the peak amplifier **4** which are both adapted to operate at that center frequency by respective input and output matching networks (not shown). During high signal peaks of the input signal Sᵢₙ, the main amplifier 3 saturates and the peak amplifier **4** takes over, thus generating an amplified output signal **Sₒᵤₜ** being provided to a load **6** (not being part of the arrangement).

The Doherty amplifier arrangement 1 of Fig. 1 provides a high power-added efficiency with input signals Sᵢₙ that have high peak-to-average ratios. However, although the theoretical efficiency characteristic of a Class-A (50 % peak efficiency) and Class-B (78 % peak efficiency) based Doherty is quite good, a measured efficiency characteristic of a Doherty amplifier arrangement, mainly based on the classical concept (curve **A**: Drain efficiency of Doherty amplifier, and for comparison reasons curve **B**: balanced-mode operation (both, main and peak transistors are operated in Class-A or B mode)) in dependence of the signal power (output of a SMIQ modulator in dBm) shown in **Fig. 2** differs from (i.e. is smaller than) the theoretically expected efficiency, e.g. due to the fact that the auxiliary amplifier 4 is permanently biased in Class-C mode and thus doesn't always deliver the optimum required performance for a Doherty amplifier arrangement.

In order to improve the efficiency of the Doherty arrangement 1 of Fig. 1, the classical Doherty amplifier arrangement 1 needs to be modified. **Fig. 3** shows an exemplarily embodiment of such a modified Doherty amplifier arrangement 1, additionally comprising a peak amplifier control unit **8** and a main amplifier control unit **9.** It will be understood that the main amplifier control unit 9 is not restricted to controlling only the main amplifier 3, but may also be used for performing part of the control of the peak amplifier 4. In particular, both the main amplifier control unit 9 and the peak amplifier control unit 8 may be integrated into a single physical entity.

The main amplifier control unit 9 is adapted for switching an (output) supply voltage **V_{ds}** of the main amplifier 3 between different (discrete) voltage levels in dependence of the input signal load. The peak amplifier control unit 8 is provided for modulating (adaptively controlling) an input supply voltage **V_{gs}** of the peak amplifier 4 in dependence of an envelope of the input signal Sᵢₙ and also in dependence of the (current) load. By combining both approaches, and applying them to the classical Doherty amplifier concept, an improved peak and back-off efficiency of the resulting advanced Doherty amplifier may be attained, as indicated by the illustrative improved efficiency curve **C** of the efficiency diagram of Fig. 3. Both amplifiers 3, 4 (resp. power transistors arranged therein) may be controlled from a digital part / frontend (e.g. FPGA), which is adapted to provided the input signal Sᵢₙ to the Doherty amplifier arrangement 1 (after digital-to-analog conversion and possibly up-conversion) and thus has knowledge both about the load situation and about the envelope of the input signal Sᵢₙ. In the following, the control of the main amplifier 3 and of the peak amplifier 4 will be described in greater detail.

In the present example, the main amplifier 3 comprises a Field Effect Transistor, FET, and the main amplifier control unit 9 is adapted for controlling an output supply voltage V_{ds} which represents a voltage between a drain and a source terminal of the FET. In the present example, the main amplifier control unit 9 is also used for controlling the output supply voltage V_{ds} of the peak amplifier 4 in a coordinated way. In particular, the output supply voltages V_{ds} provided to the main amplifier 3 and the peak amplifier 4 may be chosen to be identical. It will be understood that the approach described herein is not limited to the use of FETs, and may also be applied e.g. to bipolar transistors in an analogous way. As usual, the load of the Doherty amplifier arrangement is defined as a difference (typically measured in dB, dBm or %) from a maximum possible power which can provided by the amplifiers 3, 4.

Each of the different discrete levels of the output supply voltage V_{ds} is related to a different load scenario, defined as a respective (different) range of the load of the Doherty arrangement 1. For instance, there may be three discrete voltage levels e.g. of 15 V, 20 V, and 30 V which are provided to the main amplifier 3 by a multi-voltage-level power supply **9a**. As indicated above, each voltage level may correspond to one of three different load conditions, e.g. low load, mid load, full load, being related to e.g. from 10 % to 40 %, from 40 % to 70 %, and from 70 % to 100 % of the full power of the Doherty arrangement 1.

In order to control the output supply voltage V_{ds} of the main amplifier 3, apart from the switchable power supply 9a, basic examples of further building blocks of the main amplifier control unit 9 are given in Fig. 3. For instance, in addition to the digital frontend already described above, a controller may be provided for switching between the different voltage levels of the power supply 9a. It will be understood that in addition to the information about the current load, further information, e.g. about a current quality of the output signal Sₒᵤₜ of the Doherty amplifier arrangement 1, may be provided to the digital frontend and taken into account for controlling the main amplifier 3. The output signal may be provided to the digital frontend e.g. using a tap coupler at the output of the Doherty arrangement 1 (not shown) which may be part of a feedback-path for performing (digital) pre-distortion of the input signal Sᵢₙ.

For controlling the input supply voltage V_{gs} of the peak amplifier 4, being defined in the present example as a voltage between a gate terminal and a source terminal of a FET of the peak amplifier 4, building blocks of the peak amplifier control unit 8 may e.g. comprise one or more suitable look-up tables in the digital frontend (FPGA), relating a current value of the envelope of the input signal Sᵢₙ to the input supply voltage V_{gs} of the peak amplifier 4. Also, a suitable interface adaptation and adaptive power supply or another suitable voltage modulator may be provided to supply the adaptive input voltage V_{gs} to the peak amplifier 4. As for the main amplifier control unit 9, further input parameters may have an influence on the input supply voltage V_{gs}, for example information about a current output signal quality of the Doherty amplifier arrangement 1, and, in particular, about a (current) load of the Doherty amplifier arrangement 1.

The Doherty amplifier arrangement 1 of Fig. 3 may be used e.g. in a transmit frontend **11** of a base station **12** of a communications network (not shown), the transmit frontend 11 further comprising at least one transmit antenna for radio transmissions of the output signal Sₒᵤₜ. The transmit frontend 11 may in particular also comprise the digital frontend described above and further components such as digital-to-analog converters and mixers.

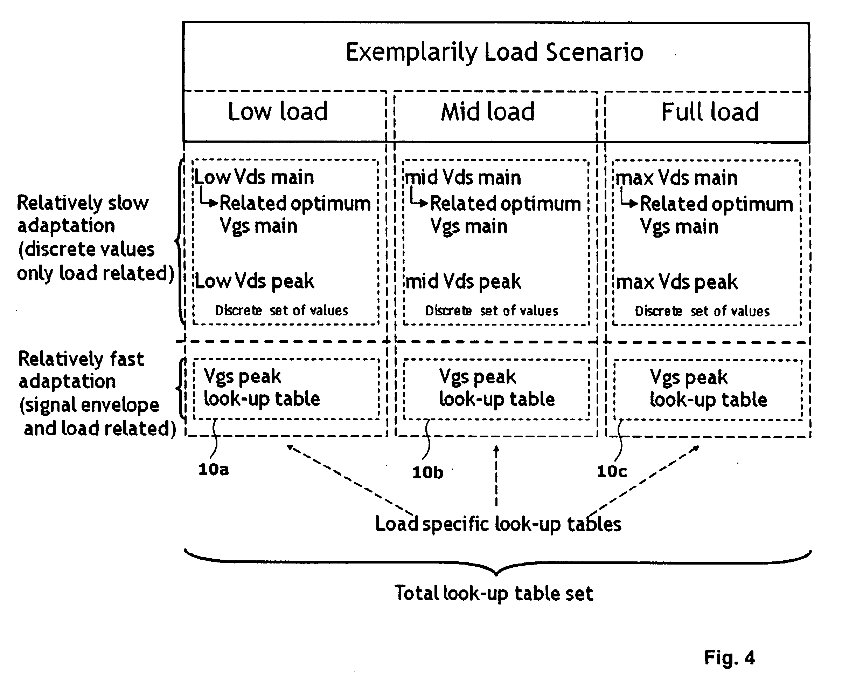

It will be understood that the two parameters - output supply voltage V_{ds} of the main amplifier 3 - and input supply voltage V_{gs} of the auxiliary / peak amplifier 4 - are typically controlled in coordination to each other, as indicated by the double-headed arrow in Fig. 3. Thus, the two approaches for efficiency improvement may be combined to a common concept, a specific implementation example thereof being represented in **Fig. 4**.

In Fig. 4, the three different load scenarios (low load, mid load, high load) described above are used for the switching of the output supply voltage V_{ds} of the main amplifier 3. The switching of the output supply voltage V_{ds} in dependence of the load results in an optimized input supply voltage V_{gs} of the main amplifier 3. In a similar way, the output supply voltage V_{ds} of the peak amplifier 4 is also switched between (three) discrete voltage values, depending on the load condition, the switching of the output supply voltage V_{ds} of the peak amplifier 4 may be performed either in the peak amplifier control unit 8 itself, or alternatively in the main amplifier control unit 9. In this case, the same multi-voltage power supply 9a may be used for providing the same switched output supply voltage V_{ds} to both amplifiers 3, 4.

As can be gathered from Fig. 4, a set of look-up tables **10a** to **10c** may be provided, each relating the envelope of the input signal Sᵢₙ to the input supply voltage V_{gs} of the peak amplifier 4 for a different load scenario. One skilled in the art will readily appreciate that although the present example has been given for three different load scenarios, an implementation using more or less than three load scenarios may be performed as well. In any case, the efficiency at back-off (supporting different load scenarios) as well as peak efficiency of the Doherty amplifier arrangement 1 may be improved by combining the two approaches in the way indicated above.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Also, the description and drawings merely illustrate the principles of the invention. It will thus be appreciated that those skilled in the art will be able to devise various arrangements that, although not explicitly described or shown herein, embody the principles of the invention and are included within its scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions.

## Claims

1. Doherty amplifier arrangement (1) for amplification of an input signal (Sᵢₙ), comprising:
a main amplification path (2a) with a main amplifier (3),
a main amplifier control unit (9) for switching an output supply voltage (V_{ds}) of the main amplifier (3) between different discrete values in dependence of a load condition of the Doherty amplifier arrangement (1), an auxiliary amplification path (2b) with a peak amplifier (4), and
a peak amplifier control unit (8) for modulating an input supply voltage (V_{gs}) of the peak amplifier (4) in dependence of an envelope of the input signal (Sᵢₙ) said Doherty amplifier arrangement being adapted for switching the supply voltage (V_{ds}) of the main amplifier (3) and for modulating the input supply voltage (V_{gs}) of the peak amplifier (4) in a coordinated way, so that for each discrete valve of the output supply voltage (V_{ds}) of the main amplifier (3) a different function relating the envelope signal to the input supply voltage (V_{gs}) is used.

2. Doherty amplifier arrangement according to claim 1, wherein the peak amplifier control unit (8) is adapted for modulating the input supply voltage (V_{gs}) of the peak amplifier (4) also in dependence of a load condition and/or of a quality of an output signal (Sₒᵤₜ) of the Doherty amplifier arrangement (1).

3. Doherty amplifier arrangement according to any one of the preceding claims, wherein at least one of the peak amplifier control unit (8) and the main amplifier control unit (9) is further adapted for switching an output supply voltage (V_{ds}) of the peak amplifier (4) in dependence of a load condition of the Doherty amplifier arrangement (1).

4. Doherty amplifier arrangement according to any one of the preceding claims, wherein the peak amplifier control unit (8) comprises at least one look-up table (10a to 10c) relating the input supply voltage (V_{gs}) to an envelope of the input signal (Sᵢₙ).

5. Doherty amplifier according to claim 4, comprising a plurality of look-up tables (10a to 10c), each for a different load condition of the Doherty amplifier arrangement (1).

6. Doherty amplifier arrangement according to any one of the preceding claims, wherein the main amplifier control unit (9) comprises a switchable power supply (9a) for generating a plurality of discrete voltage levels to be provided as supply voltages (V_{ds}) to the main amplifier (3).

7. Transmit frontend (11) for a base station (12), comprising a Doherty amplifier arrangement (1) according to any one of the preceding claims.

8. Base station (12) for mobile radio applications comprising at least one transmit frontend (11) according to claim 7.

9. Method for amplification of an input signal (Sᵢₙ) which is provided to a Doherty amplifier arrangement (1) having a main amplifier (3) and a peak amplifier (4), the method comprising:
switching an output supply voltage (V_{ds}) of the main amplifier (3) between different discrete values in dependence of a load condition of the Doherty amplifier arrangement (1), and
modulating an input supply voltage (V_{gs}) of the peak amplifier (4) in dependence of an envelope of the input signal (Sᵢₙ), wherein the switching of the supply voltage (V_{ds}) of the main amplifier (3) and the modulating of the input supply voltage (V_{gs}) of the peak amplifier (4) are performed in a coordinated way, so that for each discrete valve of the output supply voltage (V_{ds}) of the main amplifier (3) a different function relating the envelope signal to the input supply voltage (vgs) is used.

10. Method according to claim 9, wherein the modulating of the input supply voltage (V_{gs}) of the peak amplifier (3) is performed also in dependence of a load condition and/or of a quality of an output signal (Sₒᵤₜ) of the Doherty amplifier arrangement (1).

11. Method according to any one of claims 9 to 10, further comprising:
switching an output supply voltage (V_{ds}) of the peak amplifier (4) in dependence of a load condition of the Doherty amplifier arrangement (1).

12. Method according to any one of claims 9 to 11, further comprising:
relating the input supply voltage (V_{gs}) to the envelope of the input signal (Sᵢₙ) using a plurality of look-up tables (10a to 10c) for different load conditions of the Doherty amplifier arrangement (1).

13. Computer program product adapted to perform all the steps of the method according to any one of claims 9 to 12.

## Patentansprüche

1. Doherty-Verstärkeranordnung (1) zur Verstärkung eines Eingangssignals (Sᵢₙ), umfassend:
Einen Hauptverstärkungspfad (2a) mit einem Hauptverstärker (3),
eine Hauptverstärker-Steuereinheit (9) zum Schalten einer Ausgangsversorgungsspannung (V_{ds}) des Hauptverstärkers (3) zwischen unterschiedlichen diskreten Werten in Abhängigkeit von einem Lastzustand der Doherty-Verstärkeranordnung (1),
einen Hilfsverstärkungspfad (2b) mit einem Spitzenverstärker (4), und
eine Spitzenverstärker-Steuereinheit (8) zum Modulieren einer Eingangsversorgungsspannung (V_{gs}) des Spitzenverstärkers (4) in Abhängigkeit von einer Hüllkurve des Eingangssignals (Sᵢₙ), wobei die besagte Doherty-Verstärkeranordnung für das Schalten der Versorgungsspannung (V_{ds}) des Hauptverstärkers (3) und für das Modulieren der Eingangsversorgungsspannung (V_{gs}) des Spitzenverstärkers (4) in koordinierter Weise ausgelegt ist, so dass für jeden diskreten Wert der Ausgangsversorgungsspannung (V_{ds}) des Hauptverstärkers (3) eine unterschiedliche Funktion, welche das Hüllkurvensignal zu der Eingangsversorgungsspannung (V_{gs}) in Beziehung setzt, verwendet wird.

2. Doherty-Verstärkeranordnung nach Anspruch 1, wobei die Spitzenverstärker-Steuereinheit (8) dazu ausgelegt ist, die Eingangsversorgungsspannung (V_{gs}) des Spitzenverstärkers (4) ebenfalls in Abhängigkeit von einem Lastzustand und/oder einer Qualität eines Ausgangssignals (Sₒᵤₜ) der Doherty-Verstärkeranordnung (1) zu modulieren.

3. Doherty-Verstärkeranordnung nach einem beliebigen der vorstehenden Ansprüche, wobei mindestens entweder die Spitzenverstärker-Steuereinheit (8) oder die Hauptverstärker-Steuereinheit (9) weiterhin für das Schalten einer Ausgangsversorgungsspannung (V_{ds}) des Spitzenverstärkers (4) in Abhängigkeit von einem Lastzustand der Doherty-Verstärkeranordnung (1) ausgelegt ist.

4. Doherty-Verstärkeranordnung nach einem beliebigen der vorstehenden Ansprüche, wobei die Spitzenverstärker-Steuereinheit (8) mindestens eine Lookup-Tabelle (10a bis 10c), welche die Eingangsversorgungsspannung (V_{gs}) zu einer Hüllkurve des Eingangssignals (Sᵢₙ) in Beziehung setzt, umfasst.

5. Doherty-Verstärkeranordnung nach Anspruch 4, mit einer Mehrzahl von Lookup-Tabellen (10a bis 10c), von denen eine jede für einen unterschiedlichen Lastzustand der Doherty-Verstärkeranordnung (1) bestimmt ist.

6. Doherty-Verstärkeranordnung nach einem beliebigen der vorstehenden Ansprüche, wobei die Hauptverstärker-Steuereinheit (9) eine schaltbare Leistungsversorgung (9a) zum Erzeugen einer Mehrzahl von als Versorgungsspannungen (V_{ds}) an den Hauptverstärker (3) bereitzustellenden diskreten Spannungsniveaus umfasst.

7. Sende-Frontend (11) für eine Basisstation (12), umfassend eine Doherty-Verstärkeranordnung (1) gemäß einem beliebigen der vorstehenden Ansprüche.

8. Basisstation (12) für Mobilfunkanwendungen, mit mindestens einem Sende-Frontend (11) gemäß Anspruch 7.

9. Verfahren zur Verstärkung eines Eingangssignals (Sᵢₙ), welches von einer einen Hauptverstärker (3) und einen Spitzenverstärker (4) aufweisenden Doherty-Verstärkeranordnung (1) bereitgestellt wird, wobei das Verfahren umfasst:
Schalten einer Ausgangsversorgungsspannung (V_{ds}) des Hauptverstärkers (3) zwischen unterschiedlichen diskreten Werten in Abhängigkeit von einem Lastzustand der Doherty-Verstärkeranordnung (1), und
Modulieren einer Eingangsversorgungsspannung (V_{gs}) des Spitzenverstärkers (4) in Abhängigkeit von einer Hüllkurve des Eingangssignals (Sᵢₙ), wobei das Schalten der Versorgungsspannung (V_{ds}) des Hauptverstärkers (3) und das Modulieren der Eingangsversorgungsspannung (V_{gs}) des Spitzenverstärkers (4) in koordinierter Weise ausgelegt sind, so dass für jeden diskreten Wert der Ausgangsversorgungsspannung (V_{ds}) des Hauptverstärkers (3) eine unterschiedliche Funktion, welche das Hüllkurvensignal zu der Eingangsversorgungsspannung (V_{gs}) in Beziehung setzt, verwendet wird.

10. Verfahren nach Anspruch 9, wobei das Modulieren der Eingangsversorgungsspannung (V_{gs}) des Spitzenverstärkers (3) ebenfalls in Abhängigkeit von einem Lastzustand und/oder einer Qualität eines Ausgangssignals (Sₒᵤₜ) der Doherty-Verstärkeranordnung (1) durchgeführt wird.

11. Verfahren nach einem beliebigen der Ansprüche 9 bis 10, weiterhin umfassend:
Schalten einer Ausgangsversorgungsspannung (V_{ds}) des Spitzenverstärkers (4) in Abhängigkeit von einem Lastzustand der Doherty-Verstärkeranordnung (1).

12. Verfahren nach einem beliebigen der Ansprüche 9 bis 11, weiterhin umfassend:
Inbeziehungsetzen der Eingangsversorgungsspannung (V_{gs}) zur Hüllkurve des Eingangssignals (Sᵢₙ) unter Verwendung einer Mehrzahl von Lookup-Tabellen (10a bis 10c) für unterschiedliche Lastzustände der Doherty-Verstärkeranordnung (1).

13. Computerprogramm-Produkt zum Durchführen aller Schritte des Verfahrens nach einem beliebigen der Ansprüche 9 bis 12.

## Revendications

1. Montage d'amplificateur de Doherty (1) pour l'amplification d'un signal d'entrée (Sᵢₙ), comprenant :
un circuit d'amplification principal (2a) avec un amplificateur principal (3),
une unité de commande d'amplificateur principal (9) pour commuter une tension d'alimentation de sortie (V_{ds}) de l'amplificateur principal (3) entre différentes valeurs discrètes en fonction d'un état de charge du montage d'amplificateur de Doherty (1),
un circuit d'amplification auxiliaire (2b) avec un amplificateur de crête (4), et une unité de commande d'amplificateur de crête (8) pour moduler une tension d'alimentation d'entrée (V_{gs}) de l'amplificateur de crête (4) en fonction d'une enveloppe du signal d'entrée (Sᵢₙ), ledit montage d'amplificateur de Doherty étant adapté pour commuter la tension d'alimentation (V_{ds}) de l'amplificateur principal (3) et pour moduler la tension d'alimentation d'entrée (V_{gs}) de l'amplificateur de crête (4) de manière coordonnée, de sorte que pour chaque valeur discrète de la tension d'alimentation de sortie (V_{ds}) de l'amplificateur principal (3), une fonction différente mettant en rapport le signal d'enveloppe avec la tension d'alimentation d'entrée (V_{gs}) soit utilisée.

2. Montage d'amplificateur de Doherty selon la revendication 1, dans lequel l'unité de commande d'amplificateur de crête (8) est adaptée pour moduler la tension d'alimentation d'entrée (V_{gs}) de l'amplificateur de crête (4) également en fonction d'un état de charge et/ou d'une qualité d'un signal de sortie (Sₒᵤₜ) du montage d'amplificateur de Doherty (1).

3. Montage d'amplificateur de Doherty selon l'une quelconque des revendications précédentes, dans lequel au moins une unité parmi l'unité de commande d'amplificateur de crête (8) et l'unité de commande d'amplificateur principal (9) est en outre adaptée pour commuter une tension d'alimentation de sortie (V_{ds}) de l'amplificateur de crête (4) en fonction d'un état de charge du montage d'amplificateur de Doherty (1).

4. Montage d'amplificateur de Doherty selon l'une quelconque des revendications précédentes, dans lequel l'unité de commande d'amplificateur de crête (8) comprend au moins une table de consultation (10a à 10c) mettant en rapport la tension d'alimentation d'entrée (V_{gs}) avec une enveloppe du signal d'entrée (Sᵢₙ).

5. Amplificateur de Doherty selon la revendication 4 comprenant une pluralité de tables de consultation (10a à 10c), chacune pour un état de charge différent du montage d'amplificateur de Doherty (1).

6. Montage d'amplificateur de Doherty selon l'une quelconque des revendications précédentes, dans lequel l'unité de commande d'amplificateur principal (9) comprend un bloc d'alimentation (9a) commutable pour générer une pluralité de niveaux de tension discrets à fournir en tant que tensions d'alimentation (V_{ds}) à l'amplificateur principal (3).

7. Module frontal de transmission (11) pour une station de base (12), comprenant un montage d'amplificateur de Doherty (1) selon l'une quelconque des revendications précédentes.

8. Station de base (12) pour des applications radio mobiles comprenant au moins un module frontal de transmission (11) selon la revendication 7.

9. Procédé pour l'amplification d'un signal d'entrée (Sᵢₙ) qui est fourni à un montage d'amplificateur de Doherty (1) présentant un amplificateur principal (3) et un amplificateur de crête (4), le procédé comprenant les étapes suivantes :
commuter une tension d'alimentation de sortie (V_{ds}) de l'amplificateur principal (3) entre des valeurs discrètes différentes en fonction d'un état de charge du montage d'amplificateur de Doherty (1), et
moduler une tension d'alimentation d'entrée (V_{gs}) de l'amplificateur de crête (4) en fonction d'une enveloppe du signal d'entrée (Sᵢₙ), dans lequel la commutation de la tension d'alimentation (V_{ds}) de l'amplificateur principal (3) et la modulation de la tension d'alimentation d'entrée (V_{gs}) de l'amplificateur de crête (4) sont exécutées de manière coordonnée, de sorte que pour chaque valeur discrète de la tension d'alimentation de sortie (V_{ds}) de l'amplificateur principal (3), une fonction différente mettant en rapport le signal d'enveloppe avec la tension d'alimentation d'entrée (V_{gs}) soit utilisée.

10. Procédé selon la revendication 9, dans lequel la modulation de la tension d'alimentation d'entrée (V_{gs}) de l'amplificateur de crête (3) est également exécutée en fonction d'un état de charge et/ou d'une qualité d'un signal de sortie (Sₒᵤₜ) du montage d'amplificateur de Doherty (1).

11. Procédé selon l'une quelconque des revendications 9 à 10, comprenant en outre l'étape suivante :
commuter une tension d'alimentation de sortie (V_{ds}) de l'amplificateur de crête (4) en fonction d'un état de charge du montage d'amplificateur de Doherty (1).

12. Procédé selon l'une quelconque des revendications 9 à 11, comprenant en outre l'étape suivante :
mettre en relation la tension d'alimentation d'entrée (V_{gs}) avec l'enveloppe du signal d'entrée (Sᵢₙ) en utilisant une pluralité de tables de consultation (10a à 10c) pour différents états de charge du montage d'amplificateur de Doherty (1).

13. Produit de programme informatique adapté pour exécuter toutes les étapes du procédé selon l'une quelconque des revendications 9 à 12.
